Europäisches Patentamt

European Patent Office

Office européen des brevets

(19)

(11) Veröffentlichungsnummer: **0 359 983**

**A1**

# (12) EUROPÄISCHE PATENTANMELDUNG

(21) Anmeldenummer: **89114870.2**

(22) Anmeldetag: **11.08.89**

(51) Int. Cl.5: **H03H 7/01 , H01P 1/202**

(30) Priorität: **27.08.88 DE 3829106**

(43) Veröffentlichungstag der Anmeldung:
**28.03.90 Patentblatt 90/13**

(84) Benannte Vertragsstaaten:
**FR GB IT**

(71) Anmelder: **DORNIER GMBH**
**Postfach 1420**
**D-7990 Friedrichshafen 1(DE)**

(72) Erfinder: **Braubach, Harald, Dipl.-Ing.**
**Weiherstrasse 32**
**D-7775 Bermatingen(DE)**

(74) Vertreter: **Landsmann, Ralf, Dipl.-Ing.**
**c/o DORNIER GMBH Postfach 1420**
**D-7990 Friedrichshafen 1(DE)**

(54) Spulenloses Filter.

(57) In einem Filter mit in Serie geschalteten Induktivitäten sind die Induktivitäten durch wenigstens ein Koax-Kabel (10,12) gebildet. Die beiden Schirmenden (11,13,15,17) der Kabel (10,12) oder des Kabels sind leitend verbunden.

Fig. 6 a

## Spulenloses Filter

Die Erfindung betrifft ein kompaktes Filter mit geringer Bauhöhe und hoher thermischer und mechanischer Belastbarkeit.

Es ist bekannt, eine Spule in einem bestimmten Frequenzbereich durch eine kurzgeschlossene Leitung zu ersetzen. Dies ist mit Koax-Kabeln zu realisieren, wenn eine Seite der Spule an Masse liegt. Bei Serienspulen liegen beide Enden an einem von Masse verschiedenen Potential und diese Spulen können nicht ohne weiteres durch kurzgeschlossene Leitungen ersetzt werden, da die längs der Leitung auftretenden parasitären Kapazitäten nicht in die Filterberechnung mit einbezogen werden können.

Aufgabe der Erfindung ist es, ein Filter anzugeben, das die Verwendung von Spulen vermeidet.

Die Aufgabe wird durch ein Filter nach den Merkmalen des Anspruchs 1 gelöst. Ausgestaltungen sind Bestandteil von Unteransprüchen.

Sind bei einer kurzgeschlossenen Serienleitung die Abschlußimpedanzen auf beiden Seiten der kurzgeschlossenen Serienleitung etwa gleich, was in der überwiegenden Zahl der Anwendungsfälle gegeben ist (Abweichungen $\pm$ 5 bis 10 %), so kann die kurzgeschlossene, symmetrische Serienleitung mit Wellenwiderstand $Z_L$ durch zwei Koax-Kabel mit Wellenwiderstand $Z_0 = Z_L/2$ ersetzt und der Schirm der Koax-Kabel auf Masse gelegt werden. Die kurzgeschlossene Serienleitung wird in eine Transformationsleitung doppelter Länge und halben Wellenwiderstand umgewandelt.

Damit lassen sich Filter, beispielsweise Bandfilter und Tiefpaßfilter,ohne Spulen aufbauen. Die Koax-Kabel lassen sich im Gegensatz zu Spulen mit einfachen Mitteln sehr genau berechnen, sind sehr genau reproduzierbar und bedürfen keines Abgleichs. Ihre mechanische Stabilität und Festigkeit macht sie für alle Anwendungsfälle, beispielsweise auch in der Luft- und Raumfahrt oder im Kraftfahrzeug, besonders geeignet, da die bei Spulen erforderlichen Abgleichungen, die durch Erschütterungen und andere Umwelteinflüsse ständig verändert werden können, entfallen.

Sind die Abschlußimpedanzen nicht annähernd gleich, so lassen sich Koax-Kabel unterschiedlichen Wellenwiderstands verwenden. Störende, parasitäre Kapazitäten nach Masse werden eliminiert. Im Gegensatz zu Spulen beeinflussen sich die einzelnen Kabelstücke gegenseitig nicht, so daß sie beliebig geometrisch angeordnet werden können.

Die Erfindung wird anhand von Figuren näher erläutert.

Es zeigen:

Figur 1 eine Schaltungsskizze mit einer einseitig an Masse liegende Spule,
Figur 2 eine veränderte Schaltungsskizze nach Figur 1,
Figur 3 eine Schaltungsskizze mit Serienspule,
Figur 4 eine veränderte Schaltungsskizze nach Figur 3,
Figur 5 bis 7 die erfindungsgemäße Umwandlung mit Koax-Kabel,
Figur 8 bis 10 ein Schaltungsbeispiel eines 5-poligen Bandfilters,
Figur 11 eine mechanische Ausführung nach Figur 8 bis 10,
Figur 12 eine vorteilhafte Ausführung nach Figur 11.

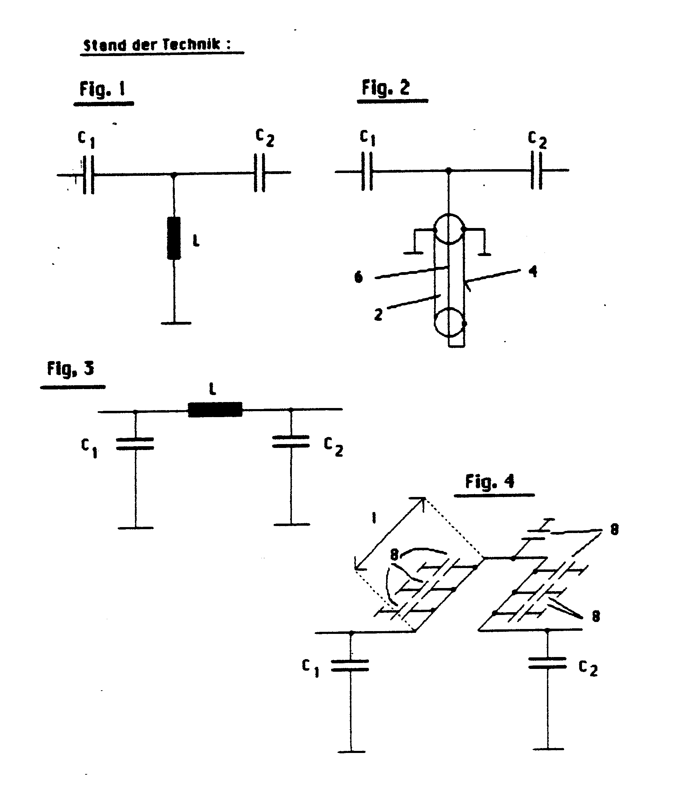

Figur 1 zeigt eine Schaltungsskizze mit zwei Kondensatoren $C_1$ und $C_2$ und einer Spule L, die mit einer Anschlußseite an Masse liegt. Diese Spule L ist in Figur 2 durch ein Koax-Kabel 2 ersetzt, wobei der Kabelschirm 4 mit einem Ende der Ader 6 des Kabels 2 kurzgeschlossen und an Masse gelegt ist.

Figur 3 zeigt eine Schaltungsskizze mit zwei an Masse gelegten Kondensatoren $C_1$ und $C_2$. Eine Spule L ist in Serie geschaltet. Diese Spule L wird in Figur 4 übergeführt in eine kurzgeschlossene symmetrische Serienleitung mit dem Wellenwiderstand

$$Z_L = \frac{\omega_0 \cdot L}{\tan(360° \cdot 1/\lambda)}$$

Diese Serienleitung ist mit parasitären Kapazitäten 8 nach Masse behaftet.

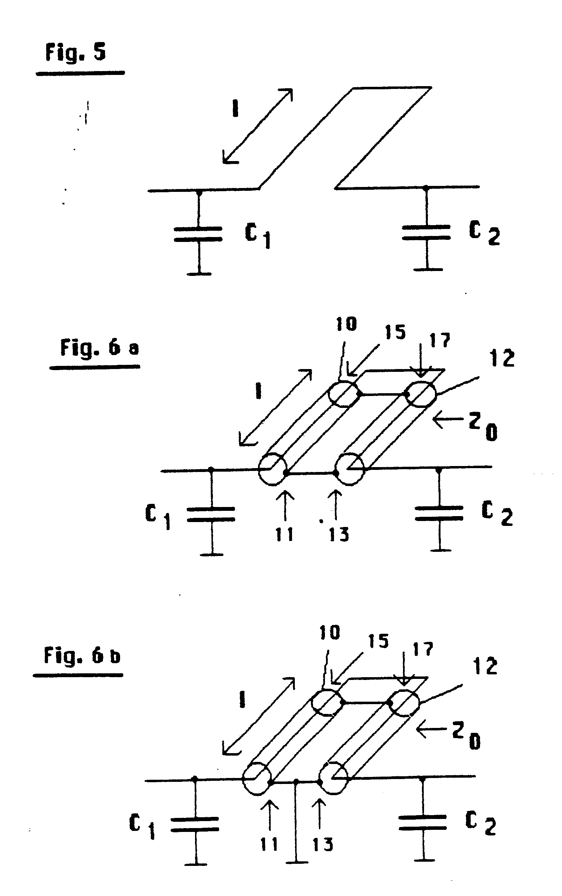

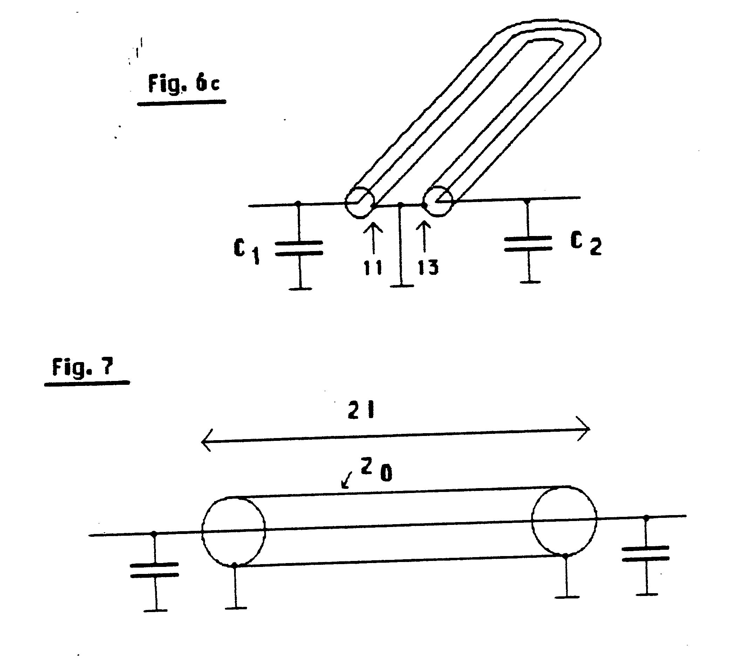

Figur 5 zeigt eine Serienschaltung nach Figur 4 mit Wellenwiderstand $Z_L$ und Kantenlänge l. Diese Serienschaltung wird in Figur 6a überführt in eine Schaltung mit zwei Koax-Kabelstücken 10 und 12. Die beiden nicht an den Kondensatoren $C_1$ und $C_2$ liegenden Leitungsenden sind miteinander kurzgeschlossen und der Schirm der beiden Kabelstücke 10 und 12 ist an den Schirmenden 11 und 13 leitend miteinander ver bunden, wobei die Verbindungsleitung sehr kurz gegenüber der Wellenlänge ist. Die beiden anderen

2

Schirmenden 15 und 17 sind ebenfalls miteinander verbunden, so daß die beiden Kabelstücke auch durch ein einziges Kabelstück ersetzt werden kann (siehe Figur 6c). Liegen die Schirmenden 11, 13 potentialfrei, so können sie an Masse gelegt werden (siehe Figur 6b). Der Wellenwiderstand der so aufgebauten Serienschaltung beträgt

$Z_0 = Z_L/2$.

Die beiden Koax-Kabelstücke 10 und 12 lassen sich durch ein Koax-Kabel 14 mit der Länge 2 • l ersetzen (siehe Figur 7).

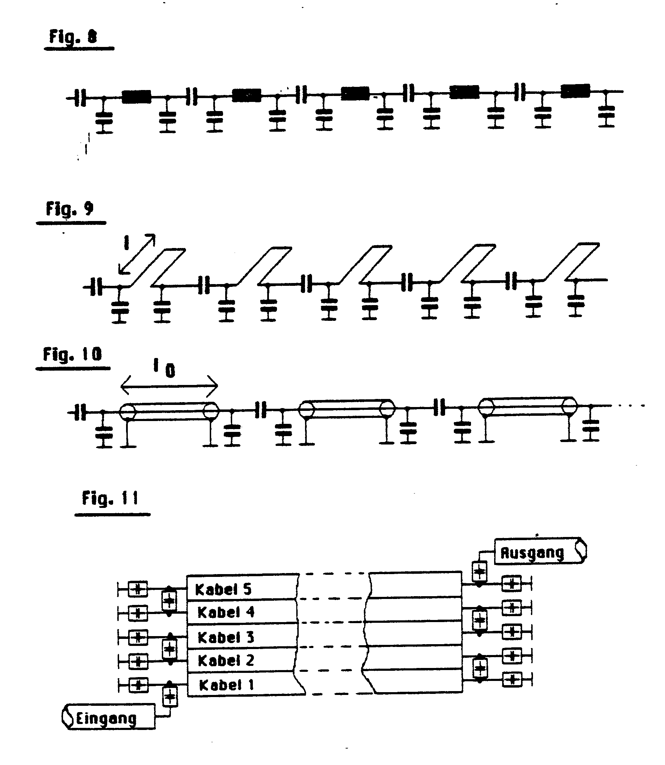

Ein Beispiel für ein 5-poliges Bandfilter zeigt die Figur 8. Alle darin verwendeten Spulen sind gleich und haben bei $\omega_0$ einen induktiven Widerstand von $X_L = 100$ Ohm.

Die Umwandlung der Schaltung in die Leitungsstruktur zeigt die Figur 9. Alle darin verwendeten Leitungen sind gleich lang mit $l = \lambda/8$. Der Wellenwiderstand beträgt

$$Z_L = \frac{\omega_0 \cdot L}{\tan(360° \cdot l/\lambda)} = \frac{100 \ \text{Ohm}}{\tan(45°)} = 100 \ \text{Ohm}$$

Figur 10 zeigt die weitere Umwandlung in die Koax-Struktur, wobei nur zwei der fünf Glieder gezeigt sind. Alle Koax- Kabelstücke haben die gleiche Länge $l_0 = 2 • l = \lambda/4$ und den Wellenwiderstand $Z_0 = Z_L/2 = 50$ Ohm. Bei allen Umwandlungen bleiben die Kapazitätswerte unverändert.

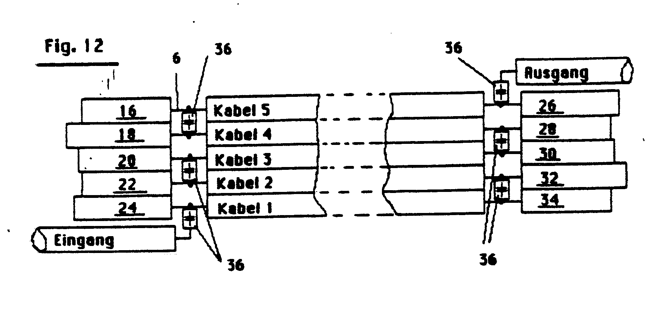

Die Figur 11 zeigt eine mögliche mechanische Ausführung eines 5-poligen Bandfilters nach den Figuren 8 bis 10. Aber auch jede andere den räumlichen Gegebenheiten angepasste Anordnung der Kabelstücke und Kondensatoren ist denkbar. Eine besonders günstige und praktische Ausführungsform zeigt die Figur 12, bei der die Kapazitäten nach Masse durch leerlaufende Koax-Kabel ersetzt sind. Dabei lassen sich die einzelnen Kabel (Kabel 1 bis Kabel 5) und die jeweils an den Enden liegenden leerlaufenden Kabelstücke 16 bis 24 und 26 bis 34 aus jeweils einem Koax-Kabelstück fertigen. Dabei wird an den Verbindungsstellen, an denen die Kondensatoren 36 angebracht werden, der Schirm und die Isolierung um die Ader 6 herum entfernt. So läßt sich das Verlöten mehrerer Kabelstücke vermeiden. Vorteilhafterweise liegen dabei die Kabel soweit voneinander entfernt, daß als Kondensatoren 36 verwendete Chip-Kondensatoren genau zwischen die Kabel passen.

Bei einem analytisch errechneten, 5-poligen Bandfilter ließen sich unmittelbar ohne Abgleich die erreichneten Filterwerte bei einem ausgeführten experimentalen Modell auch meßtechnisch ermitteln.

## Ansprüche

1. Filter mit wenigstens einem Kondensator und einer in Serie geschalteten Induktivität, **dadurch gekennzeichnet**, daß die Induktivität durch wenigstens ein Koax-Kabel (10, 12) gebildet ist und die beiden Schirmenden (11, 13) des Kabels oder der Kabel (10, 12) leitend verbunden sind, wobei die Verbindungsleitung sehr kurz gegenüber der Wellenlänge ist.

2. Filter nach Anspruch 1, dadurch gekennzeichnet, daß die Induktivität durch mehrere Koax-Kabelstücke (10, 12) gebildet ist.

3. Filter nach Anspruch 1 oder 2, dadurch gekennzeichnet, daß der Schirm (4) des Koax-Kabels (10, 12) an Masse liegt.

4. Filter nach wenigstens einem der vorherigen Ansprüche, dadurch gekennzeichnet, daß die Länge der Koax-Kabel (10, 12) vorteilhaft $l = \lambda/4$ ist.

5. Filter nach wenigstens einem der vorherigen Ansprüche, dadurch gekennzeichnet, daß die verwendeten Kondensatoren (36) Chip-Kondensatoren sind.

6. Filter nach wenigstens einem der vorherigen Ansprüche, dadurch gekennzeichnet, daß an Masse liegende Kapazitäten des Filters durch leerlaufende Koax-Kabel (16 bis 34) gebildet sind.

7. Filter nach wenigstens einem der vorherigen Ansprüche, dadurch gekennzeichnet, daß die Koax-Kabel (10, 12) parallel angeordnet sind.

8. Filter nach wenigstens einem der vorherigen Ansprüche, dadurch gekennzeichnet, daß die Koax-Kabel (10, 12) so einander zugeordnet sind, daß der Abstand der Verbindungsstellen der Größe der verwendeten Kondensatoren (36) entspricht.

9. Filter nach wenigstens einem der vorherigen Ansprüche, dadurch gekennzeichnet, daß die Koax-Kabelstücke und die leerlaufenden Koax-Kabel (16 bis 34) aus einem einzigen Koax-Kabel gebildet sind, dessen Abschirmung und Isolation an den Verbindungsstellen entfernt ist.

**Stand der Technik :**

**Fig. 1**

**Fig. 2**

**Fig. 3**

**Fig. 4**

**Fig. 5**

$I$

$C_1$

$C_2$

**Fig. 6 a**

10  15  17  12

$I$

$Z_0$

$C_1$

11  13

$C_2$

**Fig. 6 b**

10  15  17  12

$I$

$Z_0$

$C_1$

11  13

$C_2$

**Fig. 6c**

$C_1$    11   13    $C_2$

**Fig. 7**

2 l

2 0

EP 0 359 983 A1

**Fig. 8**

**Fig. 9**

**Fig. 10**

**Fig. 11**

Ausgang

Kabel 5

Kabel 4

Kabel 3

Kabel 2

Kabel 1

Eingang

**Fig. 12**

| | |
|---|---|
| 16 | Kabel 5 |
| 18 | Kabel 4 |
| 20 | Kabel 3 |
| 22 | Kabel 2 |
| 24 | Kabel 1 |

Eingang

Ausgang

| |
|---|
| 26 |
| 28 |
| 30 |
| 32 |
| 34 |

36

6

36

36

36

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-3 444 485 (OKEAN) <br> * Spalte 3, Zeilen 25-66; Spalte 4, Zeile 21 - Spalte 5, Zeile 11; Figuren 3,7 * <br> --- | 1,2,4,6 | H 03 H 7/01 <br> H 01 P 1/202 |
| A | US-A-2 196 272 (PETERSON) <br> * Seite 2, linke Spalte, Zeile 40 - rechte Spalte, Zeile 22; Figuren 5-7,9,10 * <br> --- | 1,3,4 | |
| A | TELECOMMUNICATIONS & RADIO ENGINEERING, Band 30/31, Nr. 1, 19 Januar 1976, Seiten 81-85; G.A. YUFIT: "Filter using S-sections with distributed coupling" <br> * Seite 81, Zeilen 1-12; Figur 1 * <br> --- | 1,2,4,7 | |
| A | ELECTRONIC ENGINEERING, Band 40, Nr. 489, November 1968, Seiten 643-646; R.H. BLAIR: "Simple method of constructing quarter-wave coupled coaxial bandpass filters" <br> * Seite 643, rechte Spalte, Zeilen 4-7; Seite 644, rechte Spalte, Zeilen 5-25; Figuren 5,6 * <br> ----- | 1,6 | **RECHERCHIERTE SACHGEBIETE (Int. Cl.5)** <br><br> H 03 H <br> H 01 P |

Der vorliegende Recherchenbericht wurde für alle Patentansprüche erstellt

| Recherchenort | Abschlußdatum der Recherche | Prüfer |
|---|---|---|
| DEN HAAG | 04-12-1989 | DEN OTTER A.M. |